Europäisches Patentamt

European Patent Office

Office européen des brevets

(11) Publication number: **0 143 479**
A1

## (12) EUROPEAN PATENT APPLICATION

(21) Application number: 84201441.7

(22) Date of filing: 09.10.84

(51) Int. Cl.⁴: **C 23 C 16/50, H 01 J 37/32**

(30) Priority: 19.10.83 NL 8303602

(43) Date of publication of application: 05.06.85
Bulletin 85/23

(84) Designated Contracting States: **AT BE CH DE FR GB IT LI LU NL SE**

(71) Applicant: **Hanssen, Johannes Hendrikus Leonardus,
Burg. Hermsenstraat 34, NL-6566 AG Millingen a/d Rijn
(NL)**

(72) Inventor: **Hanssen, Johannes Hendrikus Leonardus,
Burg. Hermsenstraat 34, NL-6566 AG Millingen a/d Rijn
(NL)**

(74) Representative: **Noz, Franciscus Xaverius, Ir. et al,
Boschdijk 155 P.O. Box 645, NL-5600 AP Eindhoven (NL)**

(54) Plasma-stimulated chemical vapour deposition device and, in particular, a substrate supporting and electrode disposition and associated components.

(57) A plasma-stimulated chemical vapour deposition device for the vapour deposition of layers of material on substrates, comprising a housing having an internally defined vapour deposition space and being provided with at least one gas inlet and at least one gas outlet and a gas passage defined between them for reaction gases through the vapour deposition space, if necessary a heating member for establishing a given raised temperature inside the housing, an exhaust member for establishing a given subatmospheric pressure inside the housing, a high-frequency voltage source and a substrate-supporting and electrode disposition, which is or can be arranged in the vapour deposition space of the housing and which comprises a plurality of relatively spaced, sequential electrode plates to be alternately connected to one terminal and to the other terminal of the high-frequency voltage source for establishing, in cooperation with the high-frequency voltage source, a plasma state of the gas in the vapour deposition space of the housing, which electrode plates may serve to support substrates to be processed whereby the substrate-supporting and electrode disposition comprises a vertical disposition of substantially horizontal electrode plates.

Plasma-stimulated chemical vapour deposition device and, in particular, a substrate supporting and electrode disposition and associated components.

The invention relates to a plasma-stimulated chemical vapour deposition device for the vapour deposition of layers of material on substrates, comprising a housing having an internally defined vapour deposition space and being provided with at least one gas inlet and at least one gas outlet and a gas passage defined between them for reaction gases through the vapour deposition space, if necessary, a heating member for establishing a given raised temperature inside the housing an exhaust member for establishing a given subatmospheric pressure inside the housing, a high-frequency voltage source and a substrate-supporting and electrode disposition, which is or can be arranged in the vapour deposition space of the housing and which comprises a plurality of relatively spaced, sequential electrode plates alternately connected to one terminal and the other terminal of the high-frequency voltage source for establishing, in co-operation with the high-frequency voltage source, a plasma state of the gas in the vapour deposition space of the housing, which electrode plates may serve to support substrates to be processed.

A device of the kind set forth above is known from an article by Wayne L. Johnson: "Design of plasma deposition reactors" in Solid State Technology, April 1983.

In this known device the substrate-supporting and electrode disposition is formed by a "graphite boat" on wheels, which can thus be rolled in the housing, in particular, in a quartz tube. This graphite boat comprises in particular graphite electrodes held spaced apart by insulating spacers. The substrates to be processed bear vertically on the vertically arranged graphite electrodes.

A disadvantage of this known device is that the load depends on the substrate diameter, since with the same tube diamete a larger substrate or water diameter brings about a diminution of the useful reaction surfaces and hence less substrates per load or charge (for example, 108 of 7.6 cm and 30 of 12.7 cm).

The invention has for its object to obviate said disadvantage of the known device and provides for this purpose a device of the kind set forth in the preamble which is characterized in that the substrate-supporting and electrode disposition comprises a vertical disposition of substantially horizontal electrode plates

It is noted that per se a plasma-stimulated, chemical vapour deposition device is known from the aforesaid article in which the substrate-supporting and electrode disposition comprises a vertical disposition of two substantially horizontal electrode plates. A disadvantage of this known device is, however, the low capacity, which disadvantage is likely to be become more serious when larger substrates are used and with a view to the requirements of mass production.

A further disadvantage of the above-mentioned graphite boat is that vapour deposition of conductive materials is not possible.

The invention has for its object to obviate also this disadvantage and provides for this purpose a preferred embodiment which is furthermore characterized in that the electrode plates are alternately mechanically separated from one another.

A further disadvantage of the above-mentioned graphite boat is that due to the contact of the graphite boat with the wall of the housing particles are created which give rise to a lower output of semi-conductor devices per processed semi-conductor body as a substrate.

The invention has furthermore for its object to obviate this disadvantage and provides a preferred embodiment which is characterized in that the substrate-supporting and electrode dispositic is or can be disposed free of the tube wall.

A further advantageous embodiment of the device in accordance with the invention, in particular, of the substrate-supporting and electrode disposition thereof, is characterized in that the electrode plates are provided with fastening members for fastening to at least one respective heat-resistant, rod-shaped, electrically conducting carrier or to at least one respective, electrically insulating carrier provided with an electric conductor, whilst the carriers or their conductors can be connected to a corresponding
terminal of the high-frequency voltage source and at least one of
the fastening members of each of the electrode plates is designed
so that, when fastened, it establishes an electric contact with
the respective carrier or its conductor and in that the electrode plates are held spaced apart by means of sleeve-like spacers
of heat-resistant, electrically insulating material to be arranged on
the rod-shaped carriers.

Owing to the latter aspects simple exchange of the electrode plates can be carried out, whilst by using different lengths
of the spacers an optimum electrode distance can be set in a simpler
manner.

A further advantageous embodiment of the device in accordance with the invention, in particular of the substrate-supporting
and electrode disposition thereof, is characterized in that at least
one electrode plate comprises a basic electrode plate whose top and/or
bottom surface is covered at least partly with a layer
of heat-resistant, electrically insulating material, preferably
quartz.

The last-mentioned embodiment has the advantage of the
presence of a minimum surface of electrode material proper coming
into contact with the reaction gases in the processing space.

A general advantage of the device embodying the present
invention is the high capacity independent of the substrate diameter.

The invention will now be described more fully with reference to a potential embodiment and the drawing, in which

Fig. 1 schematically shows a drastically simplified form
of a plasma-stimulated, chemical vapour deposition device in accordance with the invention,

Fig. 2 shows a potential arrangement of the substrate-
supporting and electrode disposition embodying the invention,

Fig. 3 is a plan view and a sectional view of the electrode
plate used in the substrate-supporting and electrode disposition
and

Fig. 4 shows an advantageous embodiment of the cylindrical
carrier and the spacer of the substrate-supporting and electrode
disposition co-operating with the carrier.

0143479

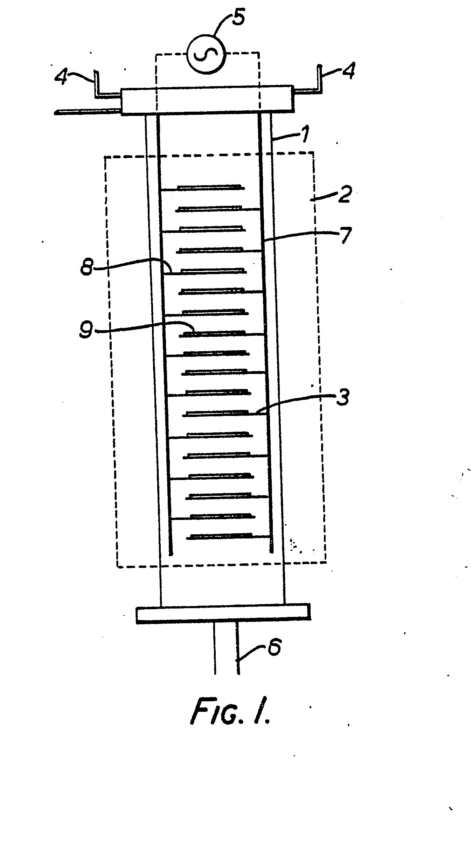

Fig. 1 shows schematically and greatly simplified an embodiment of the plasma-stimulated, chemical vapour deposition device in accordance with the invention. A housing 1, in this case a quartz tube, accom dates a substrate-supporting and electrode disposition 3. The quar tube 1 is arranged vertically and the substrate-supporting and ele trode disposition 3 comprises a vertical disposition of substantia horizontal, relatively spaced electrode plates 8. The electrode plates are alternately connected to one of two conductors 7, which are connected in turn to the respective terminal of a high-frequer voltage source 5. In operation the housing 1 is closed both on the top and the bottom sides and in this case the top side has two gas inlets 4 for reaction gases, whereas the bottom side has one gas outlet 6, which is connected in this case with an exhaust member (not shown) for establishing a subatmospheric pressure inside the housing 1. The electrode plates 8 are arranged in a vapour deposition space defined inside the housing 1 and by co-operation witl the high-frequency voltage source 5 a plasma state of the gas pha: is created in operation in the vapour deposition space of the hou: ing 1, whilst the electrode plates may serve for supporting substrates 9 to be processed. Finally, if necessary, a heating membe: 2 may be provided for creating a given raised temperature inside the housing, particularly in the vapour deposition space. Between the gas inlet and the gas outlet a passage is formed across the vapour deposition space for reaction gases. The substrate-support. and electrode disposition may be arranged in the housing, which has then to be accessible longitudinally, or it may be arranged vertically in the housing or be removed from the housing.

The plasma-stimulated chemical vapour deposition device serves to vapour-deposit materials on substrates, which may be sei conductor bodies particularly in the form of substantially circul. discs. There follows a non-limitative summary of examples of processes which can be carried out by the plasma-stimulated chemical vapour deposition device embodying the invention.

Deposition of $Si_3N_4$ by the reaction of $SiH_4$ and $NH_3$ in the plasma field.

Deposition of $SiO_2$ by the plasma reaction of $SiH_4$ and $N_2O$, in which case the $SiO_2$ may be doped with P by adding $PH_3$ to the gaseous phase.

The aforesaid processes are used in applying electrical insulating layers in the manufacture of integrated circuits and protective layers on said circuits.

Deposition of polycrystalline Si by pyrolysis in the plasma field of $SiH_4$ or $SiH_2Cl_2$. Also this layer may be dpoed with P, As or B so that a layer of doped poly is obtained.

The applications of this process are in the domain of gates for metal oxide semi-conductor devices, resistors in integrated circuits and conductive connections between components.

Deposition of amorphous silicon by pyrolysis of $SiH_4$.

This process is used in the manufacture of photo-voltaic cells and other optical components.

Deposition of metal silicides, for example, $WSi_2$, $MoSi_2$, $TiSi_2$ by the plasma reaction of metal halides with $SiH_4$.

This process is used in the manufacture of the above-mentioned gates for MOS devices and the low-resistance interconnections in particular in large-scale to very large scale integrated circuits.

Deposition of metal films, for example, Al, Ti, W by pyrolysis is the plasma field of metal compounds, which is used in the connection of components of integrated circuits.

Deposition of monocrystalline layers of, for example, Si. These layers may be simultaneously doped with the desired dopant, which process is used in the manufacture of epitaxial layers and PN junctions.

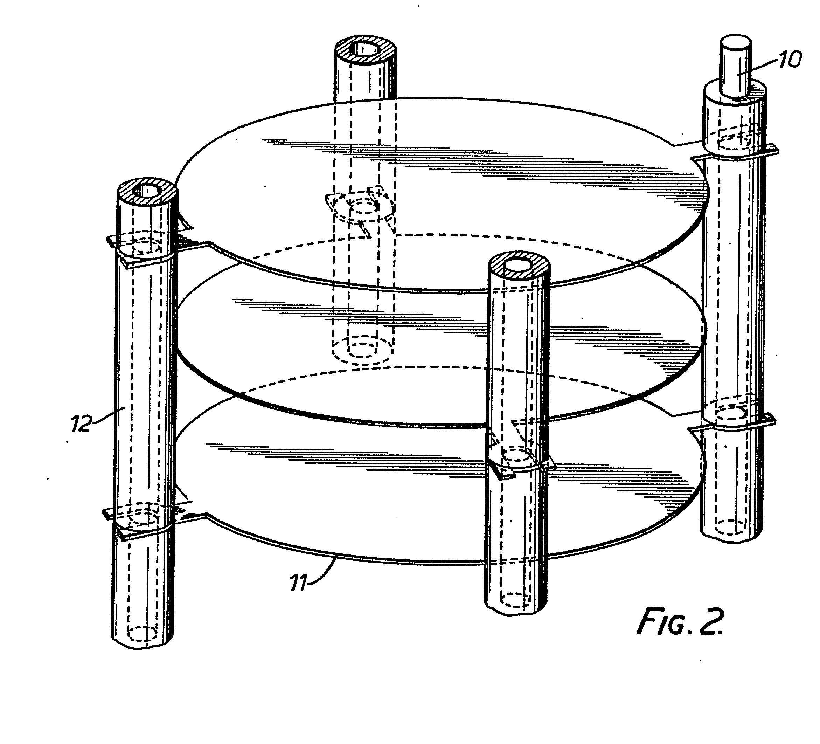

When conductive layers are vapour-deposited, there is a risk of short-circuiting between neighbouring electrode plates, which can be avoided by alternately separating the electrode plates mechanically one from the other. A potential embodiment of such an arrangement will be described in detail hereinafter with reference, in particular, to Fig. 2.

In principle the substrates can be directly disposed on the electrically conducting electrode plates. The presence of metal material or graphite in the plasma field may give rise to the release of particles which may reduce the yield of semi-conductor devices per substrate. A solution of these problems is found in covering at least partly the electrode plates with a heat-resistant, electrically insulating material, preferably quartz. For that matter, where in this description and in the claims reference is made to heat-resistant, electrically insulating material, one or more of the following materials may be meant: pure kinds of glass such as pyrex glass, alumina, ceramic and silicon carbide. A further disadvantage of metallic or graphite electrodes is that they need frequen cleaning, which is not the case with a quartz cover; the difference may be a factor 2 to 3. Said solution will also be described with reference to the embodiment to be discussed with reference to Fig. 2.

As an alternative, one or more supporting plates of heat-resistant, electrically insulating material, for example, quartz may be applied above and in the vicinity of the electrode plate, on which material the substrates are disposed.

Fig. 2 shows a possible embodiment of the substrate-supporting and electrode disposition in accordance with the invention, which comprises four cylindrical carriers 10 arranged at the corners of an imaginary rectangle made in this embodiment of heat-resistant, electrically insulating material, preferably quartz, said carriers being provided alongside, for example on the side remote from the electrode plates 11 with an electric conductor to establish contact with the mechanically connected electrode plates as will be described more fully hereinafter. The carriers need not necessarily be cylindrical, they may have other shapes of rods, whilst moreover the carriers may be made from heat-resistant, electricallly conducting material so that an electric conductor therein or theron may be omitted. It is necessary for the carriers or, for example, an electrically conducting strip connected therewith to ensure a direct connection of electrode plates with the respective terminal of the high-frequency voltage source.

It is important that the substrate-supporting and electrode disposition shown in Fig. 2 permits of vapour-depositing conductive layers since the electrode plates are alternately connected with a different diametrically opposite pair of rod-shaped carriers, whilst every pair of carriers is connected to one of the terminals of the high-frequency voltage source. It is thus not possible for two sequential electrode plates to establish an electric contact between them due to a precipitate and to a mechanical interconnection which would involve short circuit of the terminals of the high-frequency voltage source.

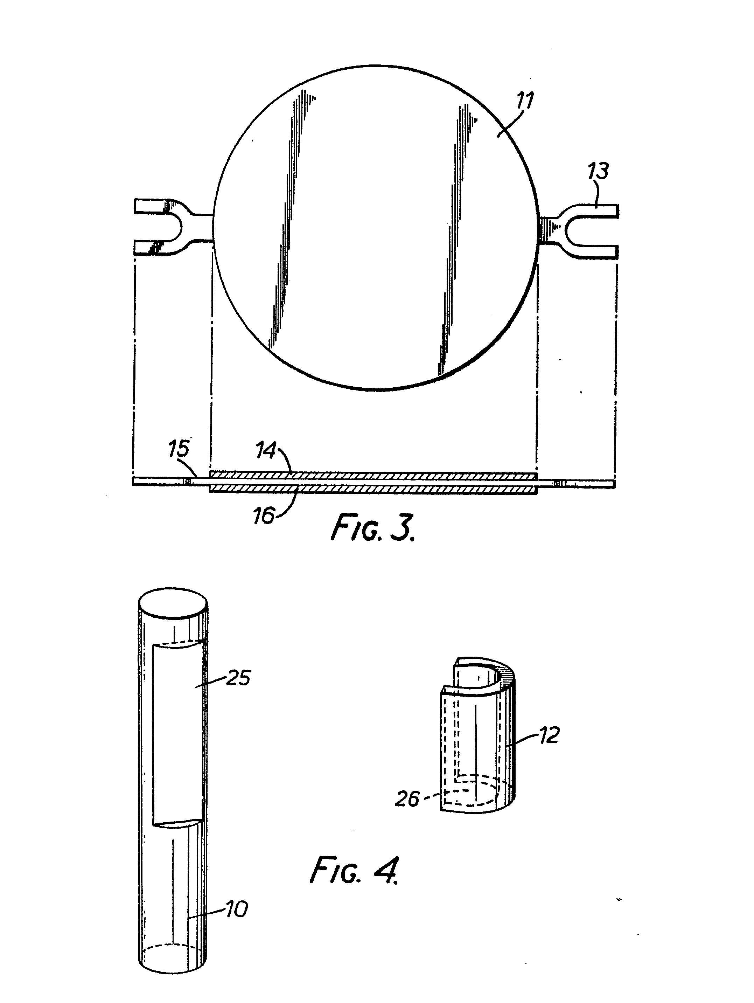

The electrode plates 11 are held spaced apart by sleeve-like spacers 12 of heat-resistant, electrically insulating material, preferably quartz. In this embodiment the electrode plates have extensions formed by open eyelets which establish a mechanical and electric contact with the carriers 10 and bear on spacers 12 disposed beneath them. The design of an electrode plate of this substrate-supporting and electrode disposition is shown in detail in Fig. 3. The electrode plate 11 comprises a basic electrode plate 15, for example, of metal or graphite, whose top and/or bottom surface may be covered at least partly with a layer of heat-resistant, electrically insulating material, preferably quartz 14 and 16 respectively. The basic electrode material graphite permits of heating the reaction surface by means of a high-frequency coil connected to a high-frequency generator. This coil may be arranged outside the quartz tube 1. The extensions 13 need not necessarily be coated on the bottom and/or top surface with quartz. If they are, a satisfactory, electric contact should be ensured between the interface 15 and the carriers 10 or, for example, an electrically conducting strip connected herewith.

The fastening members need not necessarily be open eyelets co-operating with the spacers 12; they may be apertures in the electrode plate co-operating with the spacers 12 or be closed eyelets co-operating with the spacers 12. The advantage of the open eyelets is that for removing an electrode plate from the disposition it is not necessary to remove first all superjacent electrode plates and spacers. An upward shift of these parts over a given distance is sufficient to pick the electrode plate concerned out of the disposition. Moreover, the fastening members could have the shape of hooks gripping into the carriers to that apart from a mechanical connection an electric connection is established.

It will also be obvious that it is not necessary to use four carriers and that necessarily two have to be used for establishing an alternating plasma field.

Fig. 4 shows a carrier 10 and a spacer 12 co-operating one with the other. This design of carrier and spacer may be advantageous when for structural reasons precautions are taken by which the spacers cannot be slipped off the top end of a carrier in a vertical direction, for example, in the case illustrated in Fig. 1, where the top ends of the carriers are fastened to the top closure of the housing 1. For this purpose the carriers have at the end or near the end a longitudinal flattened part 25, whilst the spacers 12 have an opening 26 in the circumferential wall matching said

- 8 -

0143479

flattened part so that the spacers 12 can be arranged in a horizonta
movement on the top side of a carrier 20 and be slipped vertically
downwards onto the carrier concerned.

The advantage of this precaution is that the distance
between the electrodes can be varied by choosing spacers of a different length. In this way a variable is obtained, which provides
additional possibilities in finding the proper process conditions.
Moreover, the various processes requiring a different distance between the electrodes can be carried out by means of the same plasma
deposition device, simply by exchanging the original spacers against
spacers of a different length.

0143479

- 1 -

## CLAIMS

1.      A plasma-stimulated chemical vapour deposition device for the vapour deposition of layers of material on substrates, comprising a housing having an internally defined vapour deposition space and being provided with at least one gas inlet and at least one gas outlet and a gas passage defined between them for reaction gases through the vapour deposition space, if necessary a heating member for establishing a given raised temperature inside the housing, an exhaust member for establishing a given subatmospheric pressure inside the housing, a high-frequency voltage source and a substrate-supporting and electrode disposition ,which is or can be arranged in the vapour deposition space of the housing and which comprises a plurality of relatively spaced, sequential electrode plates to be alternately connected to one terminal and to the other terminal of the high-frequency voltage source for establishing, in co-operation with the high-frequency voltage source, a plasma state of the gas in the vapour deposition space of the housing, which electrode plates may serve to support substrates to be processed characterized in that the substrate-supporting and electrode disposition comprises a vertical disposition of substantially horizontal electrode plates.

2.      A device as claimed in Claim 1 characterized in that at least one electrode plate comprises a basic electrode plate whose top and/or bottom surface is covered at least partly with a layer of heat-resistant, electrically insulating material.

3.      A device as claimed in Claim 1 characterized in that at least one supporting plate of heat-resistant, electrically insulating material is arranged above at least one electrode plate for supporting a substrate or substrates to be processed.

4.      A device as claimed in anyone of the preceding Claims characterized in that the electrode plates and, as the case may be, the associated supporting plate(s) are alternately mechanically separated from one another.

5. A device as claimed in anyone of the preceding Claims characterized in that the electrode plates and, as the case may be, the associated supporting plate(s) are provided with fastening members for fastening to at least one respective, heat-resistant, rod-shaped, electrically conducting carrier or to at least one respective, electrically insulating carrier provided with an electric conductor, whilst the carriers or their conductors can be connected to a corresponding terminal of the high-frequency voltage source and at least one of the fastening members of each of the electrode plates is designed so that, when fastened, it establishes an electric contact with the respective carrier or its conductor.

6. A device as claimed in Claim 5 characterized in that the substrate-supporting and electrode disposition comprises four rod-shaped carriers and in that the electrode plates and, as the case may be, the associated supporting plate(s) are alternately connected with a different pair of diametrically opposite, rod-shaped carriers each pair of carriers being connected to one of the terminals of the high-frequency voltage source.

7. A device as claimed in Claim 5 or 6 characterized in that the electrode plates and, as the case may be, the associated supporting plate(s) are held spaced apart by means of sleeve-like spacers of heat-resistant, electrically insulating material to be arranged on the rod-shaped carriers.

8. A device as claimed in Claim 7 characterized in that the rod-shaped carriers are cylindrical and have at the top or in the vicinity thereof a longitudinal flattened part, whilst the spacers have an opening in the circumferential wall matching said flattened part.

9. A device as claimed in anyone of Claims 1 to 8 in which the housing has a tubular shape, characterized in that the substrate supporting and electrode disposition is or can be disposed free of the tube wall.

10. A device as claimed in anyone of Claims 1 to 9 characteriz in that the electrode plates or basic electrode plates are made from aluminium or graphite.

11. A device as claimed in anyone of Claims 2 to 10 characterized in that the heat-resistant, electrically insulating material is quartz.

12.     A substrate-supporting and electrode disposition and component parts thereof as claimed in anyone of the preceding Claims.

FIG. 1.

0143479

Fig. 2.

*FIG. 3.*

*FIG. 4.*

0143479

European Patent Office

**EUROPEAN SEARCH REPORT**

EP 84 20 1441

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | GB-A-1 522 059 (STANDARD TELEPHONES) *The whole document* | 1 | C 23 C 16/50<br>H 01 J 37/32 |
| Y | DE-A-2 810 554 (FUJITSU)<br><br>*Whole document, in particular pages 13-14; figures 1-6* | 1,5,7,<br>10,11 | |
| Y | US-A-4 223 048 (G.M.ENGLE)<br><br>*Column 3, lines 47,57-60; column 5, lines 9-13; figures 1-6* | 1,2-7,<br>10,11 | |
| A | US-A-4 287 851 (A.R.DOZIER) | | |
| A | US-A-4 264 393 (G.J.GORIN) | | TECHNICAL FIELDS SEARCHED (Int. Cl.4) |
| A | EP-A-0 016 603 (FUJITSU) | | C 23 C 16/00<br>C 23 F 4/00 |
| A | SOLID STATE TECHNOLOGY, vol. 22, no. 12, December 1979, pages 88-92;<br>R.S.ROSLER et al.: "LPCVD-type plasma-enhanced deposition system". *Page 89, lines 29-34* | | |

The present search report has been drawn up for all claims

| Place of search | Date of completion of the search | Examiner |
|---|---|---|
| THE HAGUE | 27-01-1985 | DEVISME F.R. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82